# DEMANDE DE BREVET EUROPEEN

(11) **EP 3 101 453 A1**
(43) Date de publication de la demande: **07.12.2016**
(21) Numéro de dépôt: 16020219.8
(22) Date de dépôt: 03.06.2016
(51) Int. Cl.: G01W 1/16, G01R 15/08, G01R 15/18, G01R 19/00, G01R 19/145, H02G 13/00, G07C 9/00

(54) **COMPTEUR D'IMPACTS DE FOUDRE ET INSTALLATION COMPRENANT UN TEL COMPTEUR**

(30) Priorité: 04.06.2015 FR 1501155
(71) Demandeur: France Paratonnerres, 87068 Limoges (FR)
(72) Inventeur: Mottin, André, 26000 Valence (FR); Troubat, Michael, 87510 Saint Jouvent (FR); Kamal, Ibrahim, 87920 Condat sur Vienne (FR)
(74) Mandataire: Audic, Hervé

(57) **Abrégé**

Le compteur (110), comporte : un dispositif de traitement (112) ; un circuit d'entrée (114) destiné à être associé à une mise à terre (106) reliant un système de protection foudre (104) à la terre (108), la mise à terre (106) étant destiné à être parcouru par un courant de foudre (i) impulsionnel suite à un impact de foudre sur le système de protection foudre (104), le circuit d'entrée (114) étant destiné à fournir un courant d'entrée (i') impulsionnel à partir du courant de foudre (i) ; un étage de réveil (116) destiné à détecter l'impact de foudre à partir du courant d'entrée (i') et, suite à la détection de l'impact de foudre, à fournir au dispositif de traitement (112) un signal de détection (D) destiné à faire passer le dispositif de traitement (112) d'un mode de veille à un mode opérationnel ; au moins un étage de mesure (120, 122) destiné à fournir au dispositif de traitement (112) un signal de mesure (u₁, u₂) impulsionnel à partir du courant d'entrée (i'). Une fois passé dans son mode opérationnel, le dispositif de traitement (112) est destiné, d'une part, à mesurer la valeur de crête du courant de foudre (i) à partir d'une valeur de crête du signal de mesure (u₁, u₂) et, d'autre part, à horodater la valeur de crête mesurée du courant de foudre (i).

## Description

### DOMAINE TECHNIQUE

La présente invention concerne le comptage d'impacts de foudre.

### ARRIÈRE-PLAN TECHNOLOGIQUE

La demande de brevet chinois publiée sous le numéro CN 103529283 A décrit un compteur d'impact de foudre destiné à transmettre automatiquement le nombre d'impacts de foudre à la fois par une liaison sans fil et par une liaison filaire.

Un inconvénient de ce compteur connu est que sa consommation de courant électrique est assez élevée.

L'invention a pour but de proposer un compteur présentant une consommation moyenne de courant électrique raisonnable.

### RÉSUMÉ DE L'INVENTION

À cet effet, il est proposé un compteur d'impacts de foudre, comportant :
- un dispositif de traitement,
- un circuit d'entrée destiné à être associé à un conducteur de descente reliant un paratonnerre à la terre, le conducteur de descente étant destiné à être parcouru par un courant de foudre impulsionnel suite à un impact de foudre sur le paratonnerre, le circuit d'entrée étant destiné à fournir un courant d'entrée impulsionnel à partir du courant de foudre,
- un étage de réveil destiné à détecter l'impact de foudre à partir du courant d'entrée et, suite à la détection de l'impact de foudre, à fournir au dispositif de traitement un signal de détection destiné à faire passer le dispositif de traitement d'un mode de veille à un mode opérationnel,
- au moins un étage de mesure destiné à fournir au dispositif de traitement un signal de mesure impulsionnel à partir du courant d'entrée,
dans lequel, une fois passé dans son mode opérationnel, le dispositif de traitement est destiné, d'une part, à mesurer la valeur de crête du courant de foudre à partir d'une valeur de crête du signal de mesure et, d'autre part, à horodater la valeur de crête mesurée du courant de foudre.

Grâce à l'invention, le compteur est très économe en énergie. Par exemple, il a en effet été trouvé qu'un compteur selon l'invention pouvait consommer environ 50 µA/h sur des périodes longues alternant phases de veille et phases opérationnelles. Ainsi, la durée de vie du compteur peut être allongée. En outre, le compteur peut fonctionner avec une pile classique, sans apport d'énergie supplémentaire.

De façon optionnelle, le compteur comporte deux étages de mesure comportant respectivement deux circuits diviseur présentant des rapports de division différents, de sorte que la valeur de crête du signal de mesure du premier étage de mesure soit inférieure à la valeur de crête du signal de mesure du deuxième étage de mesure.

De façon optionnelle également, chaque étage de mesure comporte un circuit de ralentissement destiné à retarder la crête du signal de mesure par rapport à la crête du courant d'entrée.

De façon optionnelle également, le circuit de ralentissement de chaque étage de mesure comporte une capacité destinée à absorber du courant d'entrée puis à restituer le courant absorbé.

De façon optionnelle également, l'étage de réveil comporte :
- un circuit de ralentissement destiné à fournir un signal intermédiaire impulsionnel à partir du signal d'entrée, présentant une crête retardée par rapport à la crête du courant d'entrée,
- un circuit comparateur destiné à comparer le signal intermédiaire à un seuil prédéterminé pour fournir un signal de comparaison,
et le signal de détection est obtenu à partir du signal de comparaison.

De façon optionnelle également, le circuit de ralentissement de l'étage de réveil comporte une capacité destinée à absorber du courant d'entrée puis à restituer le courant absorbé.

De façon optionnelle également, les circuits de ralentissement du ou des étages de mesure et de l'étage de réveil sont configurés de sorte que la crête de chaque signal de mesure soit retardée par rapport à la crête du signal intermédiaire.

De façon optionnelle également, le compteur comporte en outre un module de communication sans fil pour transmettre une liste des valeurs de crête mesurées des courants de foudre avec leurs horodatages respectifs.

De façon optionnelle également, le module de communication sans fil est destiné à communiquer selon le standard Bluetooth.

Il est également proposé une installation de comptage d'impacts de foudre, comportant :
- un paratonnerre,
- un conducteur de descente reliant le paratonnerre à la terre,
- un compteur d'impacts de foudre selon l'invention, le circuit d'entrée étant associé au conducteur de descente.

### DESCRIPTION DES FIGURES

La figure 1 est un schéma électrique d'une installation de comptage d'impacts de foudre selon l'invention.
La figure 2 est un graphique représentant différents signaux de l'installation de comptage d'impacts de foudre en fonction du temps.

### DESCRIPTION DÉTAILLÉE

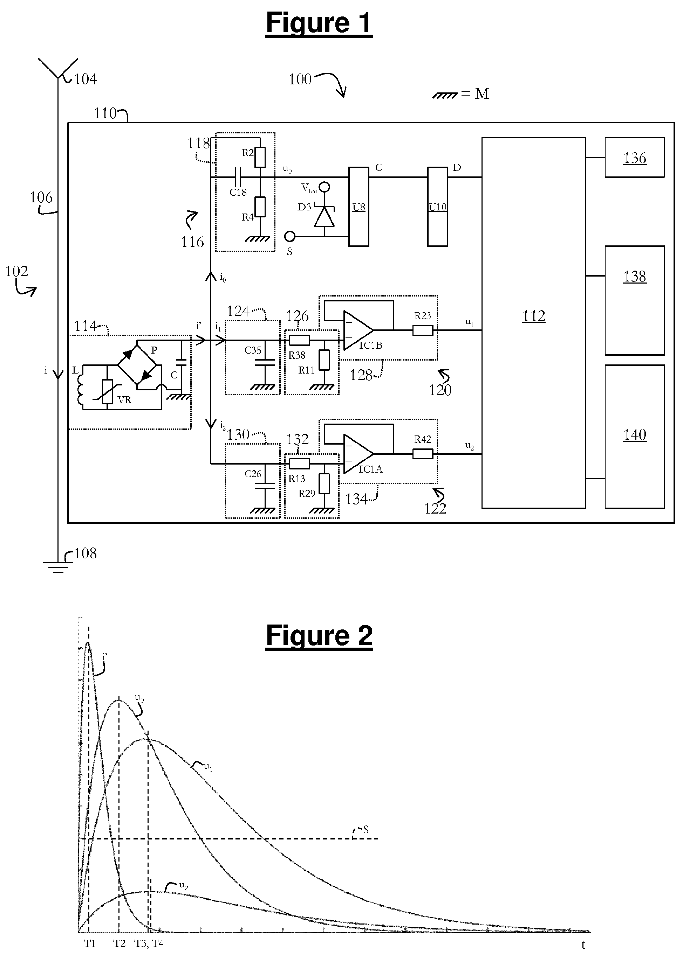

En référence à la figure 1, une installation 100 de comptage d'impacts de foudre va à présent être décrite.

L'installation 100 comporte tout d'abord un dispositif de protection contre la foudre 102 présentant, d'une part, un système de protection foudre 104 destiné à être frappé par la foudre et, d'autre part, une mise à terre 106 reliant le système de protection foudre 104 à la terre D. La mise à terre 106 est destiné à être parcouru par un courant de foudre i suite à un impact de foudre sur le paratonnerre B, pour évacuer ce courant de foudre i vers la terre D.

Le système de protection foudre 104 est par exemple un paratonnerre servant à protéger contre les impacts directs de la foudre. Dans ce cas, la mise à la terre 106 est par exemple un conducteur de descente présentant par exemple une section d'au moins 50 mm².

Alternativement, le système de protection foudre 104 peut être un parafoudre servant à protéger contre les impacts indirects de la foudre, tels que les surtensions. Dans ce cas, la mise à la terre 106 est par exemple un conducteur de mise à terre présentant par exemple une section entre 10 à 35 mm².

Le courant de foudre i est de nature impulsionnelle avec un front montant s'étendant sur un temps de montée de l'ordre de la dizaine de µs.

L'installation 100 comporte en outre un compteur 110 d'impacts de foudre.

Le compteur 110 comporte tout d'abord un dispositif de traitement 112, par exemple un dispositif de traitement numérique tel qu'un microcontrôleur. Comme cela est connu en soi, le dispositif de traitement 112 comporte une unité centrale de traitement et une mémoire, des entrées et des sorties. Le dispositif de traitement 112 est destiné à sélectivement fonctionner dans un mode de veille et dans un mode opérationnel. Le dispositif de traitement 112 consomme de préférence moins de 100 µA/h en mode de veille, par exemple autour de 50 µA/h. En outre, lorsque le dispositif de traitement 112 est en mode de veille, les autres composants du compteur 110 ont une consommation nulle ou quasi-nulle. En revanche, le dispositif de traitement 112 consomme plus de 1 mA/h en mode opérationnel. Cependant, le dispositif de traitement 112 est très peu souvent en mode opérationnel, seulement pendant les courtes périodes où la foudre est captée. Ainsi, la consommation moyenne du compteur 110 est sensiblement égale à la consommation du dispositif de traitement 112 en mode de veille.

Le compteur 110 comporte en outre un circuit d'entrée 114 destiné à être associé à la mise à terre 106 et à fournir un courant d'entrée i' impulsionnel à partir du courant de foudre i. Dans l'exemple décrit, le circuit d'entrée 114 comporte tout d'abord une bobine de détection 130 située à proximité de la mise à terre 106 de manière à être excitée par le passage du courant de foudre i pour générer le courant d'entrée i'. Le circuit d'entrée 114 comporte en outre une varistance VR en parallèle de la bobine de détection L au travers de laquelle est induit le courant d'entrée i'. Le circuit d'entrée 114 comporte en outre un pont de diodes P présentant des bornes d'entrée respectivement connectées aux extrémités de la bobine de détection L. Le circuit d'entrée 114 comporte en outre une capacité C connectée entre des bornes de sortie du pont de diodes P. Une borne de sortie du pont de diode est connectée à la masse M, tandis que l'autre borne fournit le courant d'entrée i'. Un tel circuit d'entrée 114 peut donc être monté en parallèle avec la mise à terre 106, de sorte qu'il n'y a pas besoin de couper la mise à terre 106. Ainsi, le dispositif de protection contre la foudre 102 n'est pas fragilisé.

Le compteur 110 comporte en outre un étage de réveil 116 destiné à détecter l'impact de foudre à partir du courant d'entrée i' et, suite à la détection de l'impact de foudre, à fournir au dispositif de traitement 112 un signal de détection D destiné à faire passer le dispositif de traitement 112 du mode de veille au mode opérationnel.

L'étage de réveil 116 comporte toute d'abord un circuit de ralentissement 118 destiné à fournir un signal intermédiaire u₀ impulsionnel à partir du signal d'entrée i', le front montant du signal intermédiaire u₀ étant retardé, de sorte que le signal intermédiaire présente une crête retardée par rapport à la crête du courant d'entrée i'. Ainsi, le signal intermédiaire u₀ peut se maintenir pendant quelques µs, c'est-à-dire que la durée pendant laquelle le signal intermédiaire u₀ est supérieur à sa valeur crête divisée par deux est comprise par exemple entre 2 µs et 20 µs. Plus précisément, le circuit de ralentissement 118 comporte une capacité C18 présentant une première borne connectée au circuit d'entrée 114 pour recevoir une partie i₀ du courant d'entrée i'. Le circuit de ralentissement 118 comporte en outre une résistance R4 connectée entre une deuxième borne de la capacité C18 et la masse électrique M. Le signal intermédiaire u₀ est la tension au point milieu entre la capacité C18 et la résistance R4. La capacité C18 est destinée à absorber du courant d'entrée puis à restituer le courant absorbé, ce qui retarde le front montant du signal intermédiaire u₀. Par ailleurs, dans l'exemple décrit, le circuit de ralentissement P comporte une résistance R2 en parallèle de la capacité C18, cette résistance R2 servant de protection contre les surtensions.

L'étage de réveil 116 comporte en outre un circuit comparateur U8 destiné à comparer le signal intermédiaire u₀ à un seuil prédéterminé S, pour fournir un signal de comparaison C.

Par ailleurs, une diode Zener D3 est prévue pour permettre le passage de courant depuis la source du seuil S vers une source d'alimentation V_{bat} des éléments électriques du compteur 110. Cette diode Zener D3 protège le compteur 110 des surtensions.

Le signal intermédiaire u₀, le signal de comparaison C ne dure que quelques µs, ce qui est trop court pour permettre de réveiller le dispositif de traitement 112.

Pour cette raison, l'étage de réveil 116 comporte en outre un circuit de maintien U10 destiné à maintenir le signal de comparaison pour fournir un niveau logique D constant. Dans l'exemple décrit, le circuit de maintien comporte une bascule.

Le compteur 110 comporte en outre au moins un étage de mesure 120, 122 destiné à fournir au dispositif de traitement 112 un signal de mesure u₁, u₂ impulsionnel à partir du courant d'entrée i'. Dans l'exemple décrit, le compteur 110 comporte deux étages de mesure 120, 122.

L'étage de mesure 120 est destiné à recevoir une deuxième partie i₁ du courant d'entrée i' et à fournir au dispositif de traitement 112 un signal de détection u₁ représentatif de cette deuxième partie i₁ du courant d'entée i'.

L'étage de mesure 120 comporte tout d'abord un circuit de ralentissement 124 destiné à retarder la crête du signal de mesure u₁ par rapport à la crête du courant d'entrée i'. Le retard est de préférence de quelques dizaines de ms. Ainsi, le courant de mesure u₁ peut se maintenir pendant quelques dizaines de ms, c'est-à-dire que la durée pendant laquelle le signal de mesure u₁ est supérieur à sa valeur crête divisée par deux est comprise par exemple entre 20 ms et 100 ms. Le circuit de ralentissement 124 comporte une capacité C35 dont une première borne est connectée au circuit d'entrée 114 et une deuxième borne est connectée à la masse électrique. La capacité C35 est destinée à absorber du courant d'entrée puis à restituer le courant absorbé pour ralentir le signal de mesure u₁.

L'étage de mesure 120 comporte en outre un circuit diviseur 126 destiné à réduire le signal de mesure u₁. Dans l'exemple décrit, le circuit diviseur 132 est un pont diviseur de tension comportant deux résistances R38, R11. Une première borne de la résistance R38 est connectée à la première borne de la capacité C35. Une première borne de la deuxième résistance R11 est connectée à une deuxième borne de la résistance R38 et une deuxième borne de la deuxième résistance R11 est connectée à la masse électrique M. Ainsi, le circuit diviseur 126 présente un rapport de division valant R11/(R38+R11).

L'étage de mesure 120 comporte en outre un circuit de contrôle 128 destiné à ralentir et contrôler le taux de déchargement du condensateur C35. Le circuit de contrôle 128 comporte par exemple un amplificateur opérationnel IC1B configuré en montage « suiveur ». Sa sortie est connectée à son entrée « - » et son entrée « + » est connectée au point milieu entre les résistances R38, R11. Le circuit de contrôle 128 comporte en outre une résistance R23 dont une première borne est connectée à la sortie de l'amplificateur opérationnel IC1B et une deuxième borne est connectée au dispositif de traitement S.

L'étage de mesure 122 est comporte des éléments 130, 132 et 134 respectivement identiques aux éléments 124, 126 et 128, sauf pour les résistances R13, R29 du circuit diviseur 132 qui sont choisies différentes des résistances R38, R11 du circuit diviseur 126, de sorte que les circuits diviseurs 126, 132 aient des rapports de division différents. Ainsi, la valeur de crête du signal de mesure u₁ du premier étage de mesure 120 est inférieure à la valeur de crête du signal de mesure u₂ du deuxième étage de mesure 122. De cette manière, en cas d'impact de foudre de faible intensité, le dispositif de traitement 112 peut utiliser de préférence le signal de mesure u₂ qui présente une valeur de crête plus élevée et permet donc une mesure plus précise que le signal de mesure u₂. À l'inverse, en cas d'impact de foudre de faible intensité, le dispositif de traitement 112 peut utiliser le signal de mesure u₁ permettant une mesure plus précise que le signal de mesure u₂, car ce dernier risque de faire saturer l'entrée du dispositif de traitement 112. Ainsi, cette configuration avec plusieurs étages de mesure présentant des rapports de division différents permet des mesures précises pour des valeurs de crête du courant de foudre i s'étalant sur un grand intervalle, par exemple de 1 kA à 100 kA. Les étages de mesure 120, 122 permettent ainsi de combiner une très faible consommation de courant avec des signaux de mesure u₁, u₂ précis.

Le compteur 110 comporte en outre un module de communication sans fil 136 connecté au dispositif de traitement 112 pour transmettre une liste des valeurs de crête mesurées des courants de foudre i avec leurs horodatages respectifs. Dans l'exemple décrit, le module de communication sans fil est destiné à communiquer selon le standard Bluetooth. Ainsi la collecte des données est des informations est possible via un protocole Bluetooth sur un Smartphone ou tout autre objet équipé de l'application adaptée.

Le compteur 110 comporte en outre un clavier 138 et un affichage 140 connectés au dispositif de traitement 112.

La bobine de détection L est destinée à s'étendre dans une direction sensiblement verticale correspondant à la direction de la mise à terre 106. Lorsque la bobine de détection L est dans cette position, le compteur 110 est en position de fonctionnement. L'affichage 140 est de préférence configuré pour être orienté vers le bas, avec un angle compris entre 20° et 40°, par exemple 30° lorsque le compteur 110 est en position de fonctionnement. Ainsi, l'affichage 140 est bien visible, même lorsque le compteur 110 est situé en hauteur (autour de 2 m de hauteur), comme cela est souvent le cas.

Par ailleurs, le compteur 110 présente un boîtier (non représenté) destiné à être fixé à la mise à terre 106 par des moyens d'attache (non représentés), tels que des vis. De préférence, les moyens d'attache sont accessibles et opérables par l'avant du boîtier, c'est-à-dire par le côté du boîtier à l'opposé de la mise à terre 106. Ainsi, la pose du compteur 110 est facilitée.

Par ailleurs, le dispositif de traitement 112 est de préférence configuré pour pouvoir réaliser une procédure d'auto-test du compteur 110. Au cours de cette procédure d'auto-test, le dispositif de traitement 112 commande la génération d'un courant d'entrée prédéterminé, mesure le courant d'entrée au moyen des signaux de mesure u₁, u₂, puis compare le courant d'entrée mesuré avec le courant d'entrée généré, pour détecter des composants électroniques défaillants.

Le fonctionnement de l'installation 100 va à présent être décrit en référence à la figure 2.

Le dispositif de traitement 112 est initialement dans son mode de veille.

Un impact de foudre frappe le système de protection foudre 104 entraînant l'apparition d'un courant de foudre i parcourant la mise à terre 106 vers la terre 108.

La bobine de détection L est excitée par le passage du courant de foudre i et génère un courant d'entrée i' dont la crête se trouve à un instant T1. Le courant d'entrée i' présente généralement la même forme que le courant de foudre i.

Le courant d'entrée i' se divise entre les étages de réveil 116 et de mesure 120, 122 qui reçoivent respectivement les courants i₀, i₁, i₂.

Le circuit de ralentissement 118 reçoit le courant i₀ et fournit le signal intermédiaire u₀ dont le front montant est ralentit. Ainsi, la crête du signal intermédiaire u₀ est retardée par rapport à la crête du courant d'entrée i' et se trouve donc à un instant T2 postérieur à l'instant T1.

Le circuit de comparaison U8 compare le signal intermédiaire u₀ et, tant que le signal intermédiaire u₀ dépasse le seuil S, fournit le signal de comparaison C indiquant que le signal intermédiaire u₀ dépasse le seuil S.

Le circuit de maintien U10 fournit le signal de détection D à partir du signal de comparaison C, en maintenant le signal de comparaison C.

Le dispositif de traitement 112 reçoit le signal de détection D et, en conséquence, passe du mode veille au mode opérationnel.

En parallèle, les étages de mesure 120, 122 reçoivent leurs courants i₁, i₂ respectifs et fournissent en réponse les signaux de mesure u₁, u₂ respectifs.

Du fait des circuits de ralentissement 124, 130, les fronts montants des signaux de mesure u₁, u₂ sont ralentis. Ainsi, les crêtes respectives des signaux de mesure u₁, u₂ sont retardées par rapport à la crête du courant d'entrée i' et se trouvent donc à des instants T3, T4 respectifs, chacun postérieur à l'instant T1. En outre, les instants T3, T4 sont de préférence chacun postérieur à l'instant T2. De cette manière, le dispositif de traitement 112 a le temps de se réveiller avant que les signaux de mesure u₁, u₂ n'atteignent leurs crêtes.

Une fois en mode opérationnel, le dispositif de traitement 112 sélectionne un des deux signaux de mesure u₁, u₂, par exemple, le plus grand sans que l'entrée du dispositif de traitement 112 le recevant ne sature.

Le dispositif de traitement 112 mesure alors la valeur de crête du signal de foudre i à partir de la valeur de crête du signal de mesure u₁ ou u₂ sélectionné. En particulier, le dispositif de traitement 112 tient compte des pourcentages (connus de par la conception du compteur 110) avec lesquels le courant d'entrée i' se répartit entre les courants i₀, i₁, i₂.

Le dispositif de traitement 112 horodate la valeur de crête mesurée du courant de foudre i.

Le dispositif de traitement 112 enregistre alors la valeur de crête horodatée du courant de foudre dans une mémoire, par exemple la mémoire du dispositif de traitement 112 ou bien une autre mémoire (non représentée) avec laquelle le dispositif de traitement communique 112.

Le module de communication sans fil 136 peut alors transmettre une liste des valeurs de crête mesurées des courants de foudre i avec leurs horodatages respectifs à un dispositif portable (non représenté) d'un utilisateur. Le dispositif portable est par exemple un smartphone sur lequel une application spécifique permettant la communication est installée. Le transfert de la liste peut se faire par exemple jusqu'à 50 m en espace libre. Il n'est donc pas nécessaire de s'approcher du compteur 110 pour en récupérer les informations. Il est ainsi possible d'installer le compteur dans des endroits difficilement accessibles (trappes, pied de mat de paratonnerres, mise à la terre de tableaux électriques, regard de visite, etc...). De préférence, le transfert se fait automatiquement, dès que le dispositif portable s'est appairé au module de communication sans fil 136. De préférence également, le module de communication sans fil 136 est destiné à communiquer selon le standard Bluetooth.

Une fois que la liste est sur le dispositif portable, cette liste peut être transférée sur un ordinateur, par exemple à nouveau par communication Bluetooth.

Alternativement, l'utilisateur peut utiliser le clavier 138 et l'affichage 140 pour parcourir les valeurs de crête horodatées qui ont été enregistrées.

La présente invention n'est pas limitée au mode de réalisation décrit précédemment, mais est au contraire définie par les revendications qui suivent. Il sera en effet apparent à l'homme du métier que des modifications peuvent y être apportées.

Par ailleurs, les termes utilisés dans les revendications ne doivent pas être compris comme limités aux éléments du mode de réalisation décrit précédemment, mais doivent au contraire être compris comme couvrant tous les éléments équivalents que l'homme du métier peut déduire à partir de ses connaissances générales.

## Revendications

1. Compteur (110) d'impacts de foudre, comportant :
- un dispositif de traitement (112),
- un circuit d'entrée (114) destiné à être associé à une mise à terre (106) reliant un système de protection foudre (104) à la terre (108), la mise à terre (106) étant destiné à être parcouru par un courant de foudre (i) impulsionnel suite à un impact de foudre sur le système de protection foudre (104), le circuit d'entrée (114) étant destiné à fournir un courant d'entrée (i') impulsionnel à partir du courant de foudre (i),
- un étage de réveil (116) destiné à détecter l'impact de foudre à partir du courant d'entrée (i') et, suite à la détection de l'impact de foudre, à fournir au dispositif de traitement (112) un signal de détection (D) destiné à faire passer le dispositif de traitement (112) d'un mode de veille à un mode opérationnel,
- au moins un étage de mesure (120, 122) destiné à fournir au dispositif de traitement (112) un signal de mesure (u₁, u₂) impulsionnel à partir du courant d'entrée (i'),
dans lequel, une fois passé dans son mode opérationnel, le dispositif de traitement (112) est destiné, d'une part, à mesurer la valeur de crête du courant de foudre (i) à partir d'une valeur de crête du signal de mesure (u₁, u₂) et, d'autre part, à horodater la valeur de crête mesurée du courant de foudre (i).

2. Compteur (110) selon la revendication 1, comportant deux étages de mesure (120, 122) comportant respectivement deux circuits diviseur (126, 132) présentant des rapports de division différents, de sorte que la valeur de crête du signal de mesure (u₁) du premier étage de mesure (120) soit inférieure à la valeur de crête du signal de mesure (u₂) du deuxième étage de mesure (122).

3. Compteur (110) selon la revendication 1 ou 2, dans lequel chaque étage de mesure (120, 122) comporte un circuit de ralentissement (124, 130) destiné à retarder la crête du signal de mesure (u₁, u₂) par rapport à la crête du courant d'entrée (i').

4. Compteur (110) selon la revendication 3, dans lequel le circuit de ralentissement (124, 130) de chaque étage de mesure (120, 122) comporte une capacité (C35, C26) destinée à absorber du courant d'entrée puis à restituer le courant absorbé.

5. Compteur (110) selon l'une quelconque des revendications 1 à 4, dans lequel l'étage de réveil (116) comporte :
- un circuit de ralentissement (118) destiné à fournir un signal intermédiaire impulsionnel à partir du signal d'entrée (i'), présentant une crête retardée par rapport à la crête du courant d'entrée (i'),
- un circuit comparateur (U8) destiné à comparer le signal intermédiaire (u₀) à un seuil prédéterminé (S) pour fournir un signal de comparaison,
et dans lequel le signal de détection (D) est obtenu à partir du signal de comparaison (C).

6. Compteur (110) selon la revendication 5, dans lequel le circuit de ralentissement (124, 130) de l'étage de réveil (116) comporte une capacité (C18) destinée à absorber du courant d'entrée puis à restituer le courant absorbé.

7. Compteur (110) selon la revendication 3 ou 4 et la revendication 5 ou 6, dans lequel les circuits de ralentissement (124, 130, 118) du ou des étages de mesure (120, 122) et de l'étage de réveil sont configurés de sorte que la crête de chaque signal de mesure (u₁, u₂) soit retardée par rapport à la crête du signal intermédiaire (u₀).

8. Compteur (110) selon l'une quelconque des revendications 1 à 7, comportant en outre un module de communication sans fil (136) pour transmettre une liste des valeurs de crête mesurées des courants de foudre (i) avec leurs horodatages respectifs.

9. Compteur (110) selon la revendication 8, dans lequel le module de communication sans fil (136) est destiné à communiquer selon le standard Bluetooth.

10. Installation (100) de comptage d'impacts de foudre, comportant :
- un système de protection foudre (104),
- une mise à terre (106) reliant le système de protection foudre (104) à la terre (108),
- un compteur (110) d'impacts de foudre selon l'une quelconque des revendications 1 à 9, le circuit d'entrée (114) étant associé à la mise à terre (106).
